# EUROPÄISCHE PATENTANMELDUNG

(11) **EP 1 217 654 A2**
(43) Veröffentlichungstag der Anmeldung: **26.06.2002**
(21) Anmeldenummer: 01127966.8
(22) Anmeldetag: 23.11.2001
(51) Int. Cl.: H01L 21/66

(54) **Verfahren zum Überwachen der Herstellung integrierter Schaltkreise abhängig von einem Wafer zu Waferlayoutversatz, zugehörige Anlagen und zugehöriges Programm**

(30) Priorität: 22.12.2000 DE 10064223
(71) Anmelder: Infineon Technologies AG, 81669 München (DE)
(72) Erfinder: Maeritz, Jörn, 93152 Zeiler-Nittendorf (DE); Steinkirchner, Erwin, 94315 Straubing (DE)
(74) Vertreter: Kindermann, Peter, Dipl.-Ing.

(57) **Zusammenfassung**

Erläutert wird ein Verfahren bei dem in einer Grundbelichtungsstufe ein Halbzeug belichtet wird, aus dem mehrere integrierte Schaltkreise hergestellt werden. Gemäß der Belichtung werden auf dem Halbzeug Strukturen erzeugt, die nach dem erneuten Einbringen des Halbzeuges in eine Belichtungsanlage zur Lagebestimmung genutzt werden (Schritt 112). Abhängig von der erfassten Lage des Halbzeuges und abhängig von einem Toleranzwert wird automatisch eine Prüfung auf Lagefehler ausgeführt.

## Beschreibung

Die Erfindung betrifft ein Verfahren, bei dem in einer Grundbelichtungsstufe ein Halbzeug belichtet wird, aus dem mehrere integrierte Schaltkreise hergestellt werden. Gemäß der Belichtung werden anschließend auf dem Halbzeug Strukturen erzeugt, beispielsweise in einem Ätzprozess. Das Halbzeug wird danach erneut mit Fotolack überzogen und für das Ausführen einer Folgebelichtungsstufe in eine Belichtungsanlage eingebracht. Mit Hilfe mindestens einer auf dem Halbzeug erzeugten Struktur wird die Lage des Halbzeuges bezüglich einer Einbringvorrichtung zum Einbringen des Halbzeuges automatisch erfasst.

Eine Grundbelichtung stellt die erste Belichtungsstufe eines Halbzeuges dar, z.B. eines Wafers. Das Halbzeug hat bei der Grundbelichtung eine ebene und noch unstrukturierte Oberfläche. Bei den Folgebelichtungen gibt es bereits Strukturen mit den Abmessungen von Schaltungsstrukturen.

Bisher werden bei dem eingangs genannten Verfahren beispielsweise Strichmarken erzeugt, die neben jedem Belichtungsblock in einer x-Richtung bzw. in einer senkrecht zur x-Richtung liegenden y-Richtung nebeneinander liegen. Ein sogenannter Stepper nutzt diese Strichmarken, um die richtige Belichtungsposition für die Folgebelichtungsstufen zu ermitteln.

Zur Kontrolle der Positioniergenauigkeit der Einbringvorrichtung wurden bisher in regelmäßigen zeitlichen Abständen, z.B. jede Woche einmal, Halbzeuge eingebracht, z.B. Testwafer. Die Lage der Testwafer wurde beispielsweise manuell mit Hilfe von Feinmesstechnik vermessen. Zwischen den Tests konnten unerkannte Positionierungsfehler auftreten. Außerdem war das Verfahren sehr aufwendig.

Es ist Aufgabe der Erfindung, zum Überwachen der Herstellung integrierter Schaltkreise ein einfaches Verfahren anzugeben, mit dessen Hilfe Positionierfehler insbesondere schneller als bisher und insbesondere unter weitgehender Entlastung von Bedienpersonen erfassbar sind. Außerdem sollen eine zugehörige Belichtungsanlage, eine zugehörige Datenverarbeitungsanlage und ein zugehöriges Programm angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass ein unerwünschter Versatz des Halbzeuges beim Einbringen in gewissem Maße durch die Belichtungsanlage ausgeglichen werden kann, so dass trotz des Versatzes die Folgebelichtungsstufen bezogen auf die relative Lage fehlerfrei ausgeführt werden können. Jedoch hat der Versatz zur Folge, dass nur jeweils ein Teilbereich von am Rand des Halbzeugs liegenden Schaltkreisen hergestellt werden kann. Die Folge ist eine verringerte Ausbeute.

Das erfindungsgemäße Verfahren geht von der Erkenntnis aus, dass die auf dem Halbzeug erzeugte Struktur an einer bestimmten Stelle des Halbzeuges liegen muss. Jede Abweichung von dieser Stelle bedeutet Versatz, der sich somit beim Ausrichten der Belichtungsanlage für die Folgebelichtungsstufe erfassen lässt. Außerdem geht die Erfindung von der Überlegung aus, dass der Aufwand für ein direktes Erfassen der Position des Halbzeuges sehr hoch ist.

Deshalb wird beim erfindungsgemäßen Verfahren zusätzlich zu den eingangs genannten Verfahrensschritten mindestens ein Toleranzwert vorgegeben, der ein Maß für eine maximale Lageabweichung des Halbzeuges von einer Solllage des Halbzeuges bezüglich der Einbringvorrichtung ist. Abhängig von der erfassten Lage des Halbzeuges und abhängig vom Toleranzwert wird automatisch, also nicht manuell wie bisher, eine Prüfung auf Lagefehler ausgeführt.

Beim erfindungsgemäßen Verfahren wird also die Lage des Halbzeuges an Hand der auf dem Halbzeugen aufgebrachten Strukturen ermittelt. Diese Strukturen haben eine Form, die das Erfassen erleichtert. Damit sind diese Strukturen besser zum Erfassen der Lage geeignet, als beispielsweise ein Waferrand oder eine Waferkante.

Wird ein Lagefehler erfasst, so ist die Einbringvorrichtung zu prüfen und wieder neu zu justieren, falls der Positionierfehler durch die Einbringvorrichtung und nicht durch das Halbzeug verursacht worden ist.

Bei einer Weiterbildung des erfindungsgemäßen Verfahrens wird das Halbzeug bei der Grundbelichtung mit Positioniermarken belichtet, aus denen Positionierstrukturen entstehen, die keine elektrische Funktion für einen Schaltkreis haben. Beispielsweise werden Strichmarken oder Positionierkreuze erzeugt, die beispielsweise etwa 60 µm breit und 60 µm hoch sind. Die Lage des Halbzeuges lässt sich mit Hilfe der Positionierstrukturen sicher erfassen.

Bei einer nächsten Weiterbildung werden mehrere Halbzeuge einer Fertigungseinheit gemeinsam zu einer Belichtungsanlage transportiert und/oder in eine Bearbeitungsanlage eingebracht. Die Fertigungseinheit für den Transport wird auch als Fertigungslos bezeichnet. Beispielsweise enthält ein Fertigungslos etwa 50 Halbzeuge, z.B. Siliziumscheiben, mit einem Durchmesser von sechs Zoll. Weiterhin gibt es sogenannte Fertigungshorden, die einen Rahmen zum Aufnehmen von Halbzeugen enthalten. Beispielsweise werden alle Halbzeuge einer Fertigungshorde gleichzeitig in einer Ätzanlage geätzt. Ein Fertigungslos enthält beispielsweise zwei Fertigungshorden mit jeweils 25 Wafern zu sechs Zoll.

Bei einer Weiterbildung wird die Prüfung auf Lagefehler für alle Halbzeuge einer Fertigungseinheit ausgeführt. Durch diese Maßnahme lassen sich auch nur kurzzeitig und gegebenenfalls wiederholt auftretende Positionierungsfehler sicher erfassen. Der Aufwand für die Prüfung ist jedoch höher als bei einer teilweisen Prüfung.

Bei einer alternativen Weiterbildung des erfindungsgemäßen Verfahrens wird die Prüfung auf Lagefehler nur für ein Halbzeug oder nur für wenige Halbzeuge einer Fertigungseinheit ausgeführt. Somit braucht die Lage nur für das zu prüfende Halbzeug bzw. nur für einzelne zu prüfende Halbzeuge einer Fertigungseinheit erfasst werden. Die meisten Positionierfehler treten nämlich ab einem bestimmten Zeitpunkt bei jeder Positionierung immer wieder auf, so dass ein großer Teil der Positionierfehler auch ausreichend schnell erfasst wird, wenn beispielsweise nur ein Halbzeug je Fertigungseinheit auf Lagefehler überprüft wird. Der Aufwand zum Übermitteln von Daten über ein Datenübertragungsnetz und die Beanspruchung von Rechenzeit zum Auswerten der Daten lässt sich durch die Weiterbildung um ein Mehrfaches senken im Vergleich zu einer Prüfung aller Halbzeuge.

Bei einer nächsten Weiterbildung des erfindungsgemäßen Verfahrens wird beim Erfassen des Lagefehlers die Fertigung des durch den Lagefehler betroffenen Halbzeuges oder die Fertigung aller Halbzeuge in der durch den Lagefehler betroffenen Fertigungseinheit fortgesetzt. Durch die Weiterbildung wird auch ein Aussortieren der Halbzeuge aus dem Fertigungsprozess vermieden. Es muss jedoch in Kauf genommen werden, dass die betroffenen Halbzeuge weniger funktionsfähige integrierte Schaltkreise, insbesondere im Randbereich, enthalten als ohne Versatz positionierte Halbzeuge. Beim Erfassen eines Lagefehlers wird alternativ oder kumulativ die Überprüfung der Belichtungsanlage veranlasst. Insbesondere wird die Einbringvorrichtung überprüft. Das Überprüfen der Belichtungsanlage wird vor dem Ausführen weiterer Belichtungsschritte mit der Anlage durchgeführt, so dass die Anzahl der mit Versatz belichteten Halbzeuge insbesondere der Halbzeuge, an denen eine Grundbelichtung ausgeführt wird, klein bleibt.

Eine nächste Weiterbildung des erfindungsgemäßen Verfahrens geht von der Erkenntnis aus, dass sich ein Versatz nur dann vermeiden lässt, wenn er nach dem Ausführen der Grundbelichtungsstufe aber noch vor Strukturieren des in der Grundbelichtungsstufe belichteten Halbzeuges erfasst wird. Deshalb wird bei der Weiterbildung abhängig vom Prüfergebnis die Fertigung von noch nicht strukturierten Halbzeugen gelenkt, die jedoch schon mit der Belichtungsanlage in einer Grundbelichtungsstufe belichtet worden sind oder belichtet werden. Die Weiterbildung geht von der Überlegung aus, dass die Positionierfehler nach dem erstmaligen Auftreten immer wieder auftreten, bis die Positionierfehler in einer Folgebelichtung anderer Halbzeuge erfasst und die Ursache durch eine Reparatur oder Justage der Belichtungsanlage beseitigt wird. Wird die Belichtung mit Versatz noch vor dem Ätzen der grundbelichteten Halbzeuge erfasst, so können die Halbzeuge noch nachbearbeitet werden. Das bedeutet, dass der bereits belichtete Fotolack wird wieder entfernt, neuer Fotolack aufgebracht und die Belichtung wird ohne Versatz wiederholt wird. Durch diese Maßnahme sinkt die Zahl der Halbzeuge, die mit einem Versatz strukturiert werden erheblich. Tritt kein Versatz mehr auf, so lassen sich auch Schaltkreise im Randbereich des Halbzeuges vollständig und damit fehlerfrei herstellen. Beim Entwurf der Belichtungsmaske lässt sich ein sehr kleiner Abstand der Schaltungsstrukturen zum Rand wählen. Dies führt zu einer hohen Ausnutzung der zur Verfügung stehenden Fläche und einer sehr hohen Ausbeute.

Bewusst werden abwechselnd auf einer Belichtungsanlage Grundbelichtungen und Folgebelichtungen ausgeführt. Dadurch lässt sich die Zeit bis zum Erfassen eines Versatzes erheblich verkürzen.

Bei einer nächsten Weiterbildung wird mindestens eines der folgenden Toleranzmaße erfasst und für die Prüfung eingesetzt:
- ein Versatz in x-Richtung,
- ein Versatz in eine um 90° quer zur x-Richtung liegende y-Richtung, und
- ein Winkelversatz Θ als Maß für die Drehung des Halbzeuges um seine Mittelachse.

Durch Einbeziehen aller drei Toleranzmaße lassen sich die Positionierfehler vollständig erfassen.

Die Erfindung betrifft außerdem eine Belichtungsanlage und eine Datenverarbeitungsanlage, die zum Ausführen des erfindungsgemäßen Verfahrens oder einer seiner Weiterbildungen geeignet sind. Weiterhin betrifft die Erfindung ein Programm zur Ausführung des erfindungsgemäßen Verfahrens bzw. einer seiner Weiterbildungen. Für die Belichtungsanlage, für die Datenverarbeitungsanlage und für das Programm gelten damit die oben genannten technischen Wirkungen.

Im Folgenden werden Ausführungsbeispiele der Erfindung an Hand der beiliegenden Zeichnungen erläutert. Darin zeigen:
- Figur 1: eine Siliziumscheibe (Wafer) und für das Erfassen von Positionierfehlern festgelegte Toleranzmaße,
- Figur 2: Verfahrensschritte beim zweiten Belichtungsvorgang der Siliziumscheiben eines Fertigungsloses,
- Figur 3: Verfahrensschritte zum Erfassen von Positionierfehlern, und
- Figur 4: die Darstellung von Positionierfehlern für die Fertigungseinheiten einer Tagesproduktion.

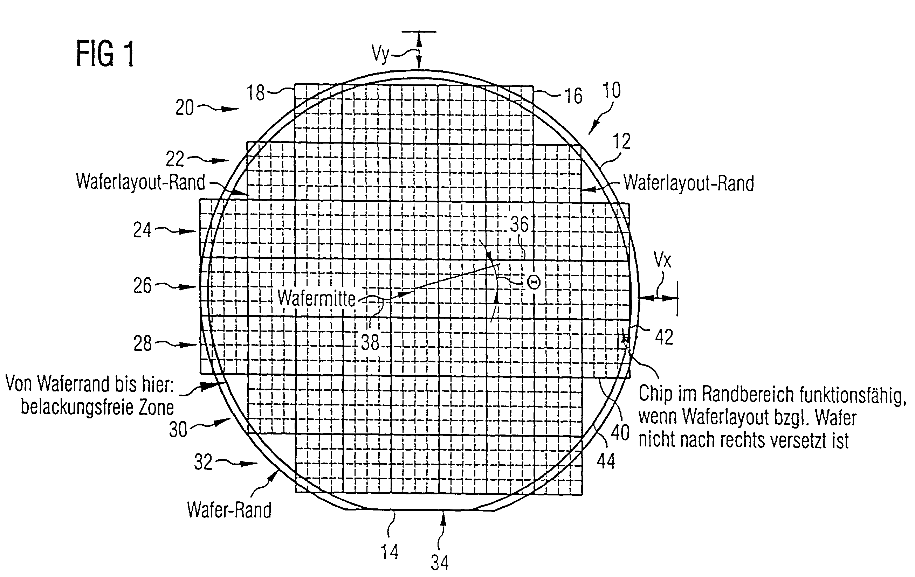

Figur 1 zeigt eine Siliziumscheibe 10, die beispielsweise einen Durchmesser von 6 Zoll hat. Die Siliziumscheibe 10 ist kreisförmig und an einer Seite abgeflacht, siehe Randverlauf 12 bzw. 14. Außerdem ist in Figur 1 der Siliziumscheibe 10 ein Layout 16 für eine Vielzahl von auf der Siliziumscheibe 10 zu fertigenden integrierten Schaltkreisen überlagert. Das Layout 16 wird durch 51 untereinander gleichartig ausgeleuchtete Belichtungsblöcke gebildet, siehe beispielsweise Belichtungsblock 18 in der oberen linken Ecke des Layouts 16. Die Belichtungsblöcke sind in Zeilen 20 bis 32 aufgereiht, die in dieser Reihenfolge in einer quer zur Zeilenrichtung (x-Richtung) liegenden Spaltenrichtung (y-Richtung) nebeneinander liegen. Die Zeilen 20 bis 32 enthalten in dieser Reihenfolge fünf, sieben, neun, neun, neun, sieben und fünf Belichtungsblöcke. Die mittleren Belichtungsblöcke jeder Zeile 20 bis 32 liegen in einer Spalte 34. Ein im Schnittpunkt der Zeile 26 und der Spalte 34 liegender Belichtungsblock 36 liegt Idealerweise mit seinem Mittelpunkt in der Mitte 38 der Siliziumscheibe 10.

Jeder Belichtungsblock 16 enthält das Layout von 4 x 4 = 16 integrierten Schaltkreisen, siehe gestrichelte Linien. Die Layouts eines Belichtungsblockes sind untereinander gleich.

Ein am rechten Rand der Siliziumscheibe 10 liegender Belichtungsblock 40 enthält beispielsweise ein Einzellayout 42, das bei exakt zentriertem Layout 16 noch vollständig auf der Siliziumscheibe 10 Platz findet. Dabei ist der Abstand einer belackungsfreien Zone 44 bereits berücksichtigt. Die belackungsfreie Zone 44 hat im Bereich des gesamten Randes der Siliziumscheibe 10 beispielsweise etwa eine Breite von 1 mm zum Waferrand.

Ein Versatz Vx in Zeilenrichtung der Belichtungsblöcke darf einen vorgegebenen x-Toleranzwert von beispielsweise 150 µm nicht überschreiten. Ein Versatz Vy in Spaltenrichtung der Belichtungsblöcke darf beispielsweise ebenfalls den Wert von 150 µm nach oben oder nach unten nicht überschreiten. Ein Winkelversatz Θ darf beispielsweise nicht größer als eine Winkelsekunde sein, um noch eine ausreichend hohe Ausbeute im Bereich des Randes der Siliziumscheibe 10 zu erzielen.

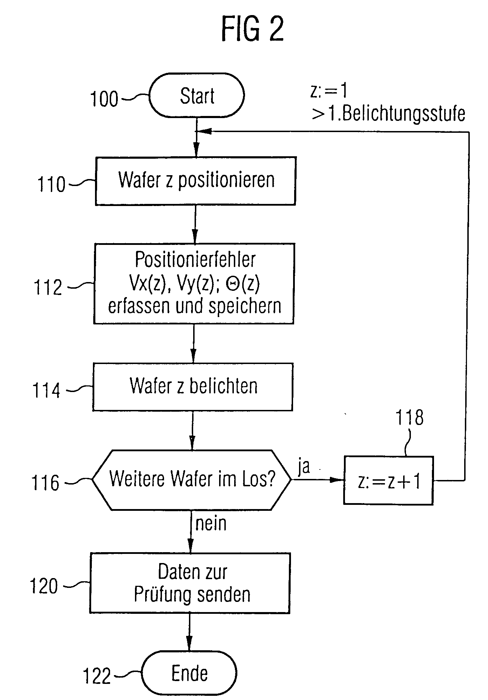

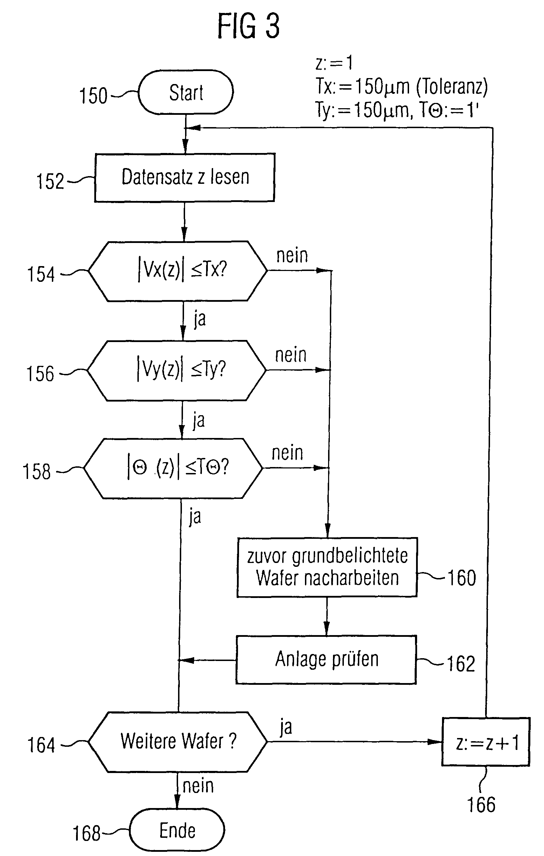

Figur 2 zeigt Verfahrensschritte, die beim Durchführen des zweiten Belichtungsvorganges für die Siliziumscheiben eines Bezugsfertigungsloses ausgeführt werden. Das Verfahren beginnt mit einem Verfahrensschritt 100. Eine Zählvariable z wird mit dem Wert Eins belegt. Vor dem Ausführen des Verfahrensschrittes 100 wurde mit derselben Belichtungsanlage, mit der das Bezugsfertigungslos belichtet wird, die Grundbelichtungsstufe für ein anderes Fertigungslos ausgeführt, das im Folgenden als vorhergehendes Fertigungslos bezeichnet wird. Mit der weiteren Bearbeitung des vorhergehenden Fertigungsloses wird gewartet, bis das unten an Hand der Figuren 2 und 3 erläuterte Prüfverfahren ausgeführt ist.

In einem dem Verfahrensschritt 100 folgenden Verfahrensschritt 110 wird der erste Wafer des Bezugsfertigungsloses auf einem Belichtungstisch positioniert. In einem folgenden Verfahrensschritt 112 sucht die Belichtungsanlage automatisch seitliche Markierungen an den Rändern vorgegebener Belichtungsblöcke, um daran die Belichtung auszurichten. Beim Suchen der Markierungen wird der Versatz Vx(z), der Versatz Vy(z) und der Winkelversatz Θ(z) jeweils bezüglich des Koordinatensystems eines Fertigungstisches zum Halten des Wafers für den aktuell bearbeiteten Wafer erfasst. Ist die Belichtungsanlage ausgerichtet, so wird der aktuell bearbeitete Wafer in einem Verfahrensschritt 114 belichtet.

In einem Verfahrensschritt 116 wird geprüft, ob das Fertigungslos noch weitere zu bearbeitende Wafer enthält. Ist dies der Fall, so wird in einem Verfahrensschritt 118 die Zählvariable z um den Wert Eins erhöht. Anschließend wird das Verfahren im Verfahrensschritt 110 mit der Bearbeitung des nächsten Wafers im Bezugsfertigungslos fortgesetzt.

Das Verfahren befindet sich in einer Verfahrensschleife aus den Verfahrensschritten 110 bis 118. Die Verfahrensschleife wird im Verfahrensschritt 116 erst dann verlassen, wenn alle Wafer des Bezugsfertigungsloses bearbeitet worden sind. In diesem Fall folgt unmittelbar nach dem Schritt 116 ein Verfahrensschritt 120, in welchem alle im Verfahrensschritt 112 ermittelten Versatzwerte zur Prüfung an einen zentralen Rechner gesendet werden, der mehrere Belichtungsanlagen überwacht. Anschließend wird die erste Stufe des Prüfverfahrens, nämlich das Erfassen der Versatzwerte, in einem Verfahrensschritt 122 beendet.

Figur 3 zeigt Verfahrensschritte zum Erfassen von Positionierfehlern. Das Verfahren wird durch den zentralen Rechner ausgeführt und beginnt in einem Verfahrensschritt 150 mit dem Empfang der im Verfahrensschritt 120 gesendeten Daten. Zu Beginn wird eine Zählvariable z auf den Wert Eins gesetzt. Für den Versatz Vx in Zeilenrichtung wird eine Toleranz Tx von 150 µm vorgegeben. Für den Versatz Vy in Spaltenrichtung wird ein Toleranzwert Ty von 150 µm vorgegeben. Für den Winkelversatz Θ wird ein Toleranzwert TΘ von einer Winkelsekunde vorgegeben.

In einem dem Verfahrensschritt 150 folgenden Verfahrensschritt 152 wird der im Verfahrensschritt 112 für den ersten Wafer der Bezugsfertigungseinheit gespeicherte Datensatz gelesen. In einem Verfahrensschritt 154 wird der Betrag des Versatzes Vx(z) des ersten Wafers gebildet und es wird geprüft, ob der Betrag kleiner als der oder gleich dem Toleranzwert Tx in x-Richtung ist. Wurde die Toleranz in x-Richtung nicht eingehalten, so folgt unmittelbar nach dem Verfahrensschritt 154 ein unten näher erläuterter Verfahrensschritt 160. Wurde die Toleranz in x-Richtung dagegen eingehalten, so folgt unmittelbar nach dem Verfahrensschritt 154 ein Verfahrensschritt 156.

Im Verfahrensschritt 156 wird der Betrag des Versatzes Vy(z) für den aktuell bearbeiteten Datensatz ermittelt. Anschließend wird geprüft, ob der Betrag des Versatzes Vy(z) kleiner oder gleich dem Toleranzwert Ty in y-Richtung ist. Ist die Toleranz in y-Richtung nicht eingehalten, so folgt dem Verfahrensschritt 156 der Verfahrensschritt 160, der wie bereits erwähnt, unten näher erläutert wird. Wird dagegen im Verfahrensschritt 156 festgestellt, dass auch die Toleranz in y-Richtung eingehalten worden ist, so folgt unmittelbar nach dem Verfahrensschritt 156 ein Verfahrensschritt 158.

Im Verfahrensschritt 158 wird der Betrag für den Winkelversatz Θ(z) des aktuell bearbeiteten Datensatzes gebildet. Anschließend wird dieser Betragswert mit dem Toleranzwert TΘ für den Winkelversatz verglichen. Ist der Betrag kleiner oder gleich eine Winkelsekunde, so folgt nach dem Verfahrensschritt 158 der Verfahrensschritt 160. Wird dagegen im Verfahrensschritt 158 festgestellt, dass die Toleranz TΘ für den Winkelversatz Θ eingehalten worden ist, so folgt unmittelbar nach dem Verfahrensschritt 158 ein unten näher erläuterter Verfahrensschritt 164.

Wurde eine der in den Verfahrensschritten 154 bis 158 überprüften Toleranzen nicht eingehalten, so wird der Verfahrensschritt 160 ausgeführt. Im Verfahrensschritt 160 wird die Nachbearbeitung der Wafer des vorhergehenden Fertigungsloses veranlasst, das bedeutet, dass diese Wafer entlackt, erneut belichtet und anschließend geätzt werden. Auch bei dem zweiten Belichtungsvorgang lässt sich vor dem Ätzen eine Prüfung auf Waferversatz durchführen.

Der im aktuellen Durchlauf geprüfte Wafer z wird trotz des Versatzes weiterbearbeitet. Eine Ausbeuteeinbuße aufgrund der Ausfälle in den Randbereichen des Wafers wird hingenommen. Alternativ wird der Wafer z oder das ganze Bezugsfertigungslos aus der Fertigung genommen. Insbesondere wird die Fertigung des Bezugsfertigungsloses abgebrochen, wenn erst wenige Fertigungsschritte ausgeführt worden sind.

Nach dem Verfahrensschritt 160 folgt ein Verfahrensschritt 162, in welchem die zur Belichtung des Bezugsfertigungsloses und auch zur Belichtung des vorhergehenden Fertigungsloses eingesetzte Belichtungsanlage überprüft wird. Stellt sich heraus, dass der Versatz auf einen Fehler der Belichtungsanlage zurückzuführen ist, so wird dieser Fehler beseitigt, bevor weitere Belichtungsschritte mit der Belichtungsanlage durchgeführt werden. Nach dem Verfahrensschritt 162 folgt ein Verfahrensschritt 164.

Im Verfahrensschritt 164 wird geprüft, ob für das aktuell zu prüfende Fertigungslos weitere Datensätze vorhanden sind. Ist dies der Fall, so folgt ein Verfahrensschritt 166, in dem die Zählvariable z um den Wert Eins erhöht wird. Anschließend wird das Verfahren mit dem Verfahrensschritt 152 fortgesetzt, so dass eine Verfahrensschleife aus den Verfahrensschritten 152 bis 166 durchlaufen wird. Innerhalb dieser Verfahrensschleife werden alle Datensätze auf Positionierfehler überprüft. Die Verfahrensschleife wird im Verfahrensschritt 164 erst dann verlassen, wenn alle Datensätze überprüft worden sind. Sind alle Datensätze überprüft worden, so wird das Verfahren in einem Verfahrensschritt 168 beendet.

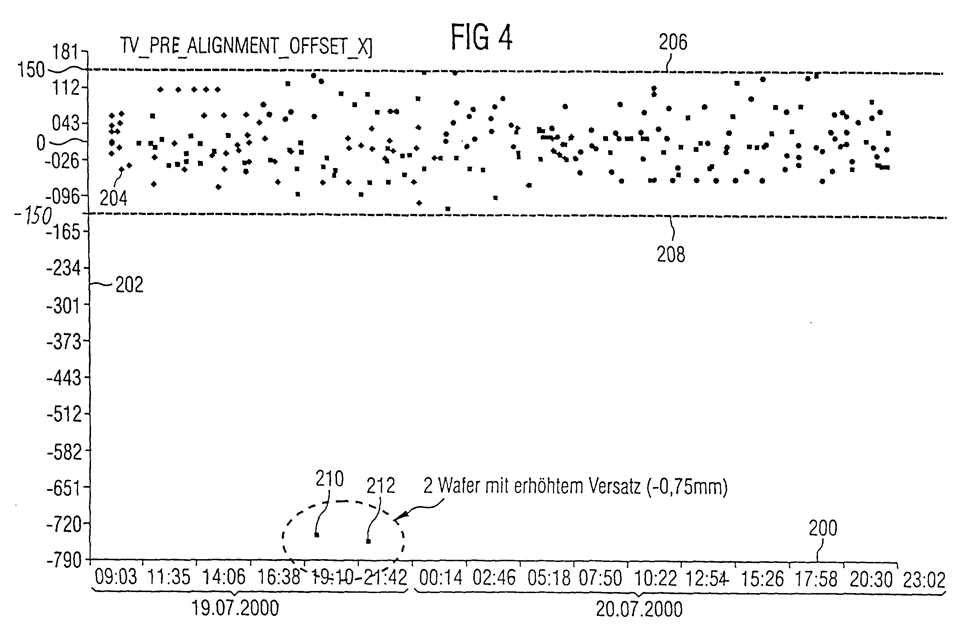

Figur 4 zeigt die Darstellung von Positionierfehlern für die Fertigungseinheiten einer Tagesproduktion. Im Unterschied zu dem an Hand der Figuren 2 und 3 erläuterten Verfahren wird bei dem in Figur 4 dargestellten Ausführungsbeispiel nur der letzte Wafer eines Fertigungsloses auf Versatz geprüft. Demzufolge werden auch nur für diesen Wafer der Versatz Vx in Zeilenrichtung, der Versatz Vy in Spaltenrichtung und der Winkelversatz Θ erfasst. Für die anderen Wafer des jeweiligen Fertigungsloses wird kein Versatz erfasst.

Auf einer Abszissenachse 200 sind die Fertigungszeit und das Fertigungsdatum dargestellt. Eine Ordinatenachse 202 zeigt den Versatz Vx für den jeweils letzten Wafer einer Fertigungseinheit.

In Figur 4 sind Versatzwerte Vx für verschiedene Belichtungsanlagen dargestellt, so dass zu einem bestimmten Zeitpunkt mehrere Werte Vx auftreten können. Ein Punkt 204 zeigt beispielsweise einen Versatz Vx von ca. -50 um für eine Fertigungseinheit, die etwa um 10.00 Uhr belichtet worden ist. Die Toleranzgrenzen für den Versatz Vx in Zeilenrichtung von 150 µm und -150 µm sind durch gestrichelte Linien 206 bzw. 208 dargestellt.

Zwei Punkte 210 und 212 liegen außerhalb der Toleranzgrenzen 206 und 208. Der Punkt 210 stellt den Versatz Vx einer Fertigungseinheit dar, die am 19.7.2000 gegen 19.20 Uhr gefertigt worden ist. Der Versatz Vx beträgt etwa -75 mm. Aufgrund dieses großen Versatzes Vx wurde die betreffende Belichtungsanlage geprüft. Es stellte sich heraus, dass eine Haltefeder abgebrochen war. Die zwischen der letzten Prüfung, bei der kein fehlerhafter Versatz festgestellt worden ist, und der durch den Punkt 210 bzw. 212 angedeuteten Prüfung mit der betreffenden Anlage grundbelichteten Wafer wurden nachgearbeitet.

## Patentansprüche

1. Verfahren zum Überwachen der Herstellung integrierter Schaltkreise,
bei dem in einer Grundbelichtungsstufe ein Halbzeug (10) belichtet wird, aus dem mehrere integrierte Schaltkreise hergestellt werden,
bei dem gemäß der Belichtung Strukturen auf dem Halbzeug (10) erzeugt werden,
bei dem das Halbzeug (10) für das Ausführen einer Folgebelichtungsstufe in eine Belichtungsanlage eingebracht wird,
bei dem mit Hilfe mindestens einer auf dem Halbzeug (10) aufgebrachten Struktur die Lage des Halbzeuges (10) bezüglich einer Einbringvorrichtung zum Einbringen des Halbzeuges (10) automatisch erfasst wird (Schritt 112),
bei dem mindestens ein Toleranzwert vorgegeben wird, der ein Maß für eine maximale Lageabweichung des Halbzeuges (10) von einer Solllage des Halbzeuges (10) bezüglich der Einbringvorrichtung ist (Schritt 150),
und bei dem abhängig von der erfassten Lage des Halbzeuges (10) und abhängig von dem Toleranzwert automatisch eine Prüfung auf Lagefehler ausgeführt wird (Schritte 154 bis 158).

2. Verfahren nach Anspruch 1, **dadurch gekennzeichnet,dass** das Halbzeug (10) bei der Grundbelichtung mit Positioniermarken belichtet wird, aus denen Positionierstrukturen entstehen, die keine elektrische Funktion für den Schaltkreis haben,
und dass die Lage mit Hilfe der Positionierstrukturen erfasst wird.

3. Verfahren nach Anspruch 1 oder 2, **dadurch gekennzeichnet,dass** mehrere Halbzeuge (10) einer Fertigungseinheit gemeinsam zu einer Belichtungsanlage transportiert und/oder in eine Belichtungsanlage eingebracht werden.

4. Verfahren nach Anspruch 3, **dadurch gekennzeichnet, dass** die Prüfung auf Lagefehler für alle Halbzeuge (10) einer Fertigungseinheit ausgeführt wird.

5. Verfahren nach Anspruch 3, **dadurch gekennzeichnet, dass** die Prüfung auf Lagefehler nur für ein Halbzeug (10) einer Fertigungseinheit oder nur für wenige Halbzeuge (10) einer Fertigungseinheit ausgeführt wird,
und/oder dass vorzugsweise die Lage nur für das zu prüfende Halbzeug (10) erfasst wird.

6. Verfahren nach einem der vorhergehenden Ansprüche, **dadurch gekennzeichnet, dass** beim Erfassen eines Lagefehlers die Fertigung des durch den Lagefehler betroffenen Halbzeuges oder die Fertigung der Halbzeuge der durch den Lagefehler betroffenen Fertigungseinheit fortgesetzt oder abgebrochen wird,
und/oder dass beim Erfassen eines Lagefehlers die Überprüfung der Belichtungsanlage (Schritt 162), insbesondere die Überprüfung der Einbringvorrichtung veranlasst wird.

7. Verfahren nach einem der vorhergehenden Ansprüche, **dadurch gekennzeichnet, dass** abhängig vom Prüfergebnis die Fertigung von noch nicht strukturierten Halbzeugen (10) gelenkt wird, die mit der Belichtungsanlage in einer Grundbelichtungsstufe belichtet worden sind (Schritt 160).

8. Verfahren nach einem der vorhergehenden Ansprüche, **dadurch gekennzeichnet, dass** ein x-Toleranzwert (Tx) für einen Versatz (Vx) des Halbzeuges (10) in eine x-Richtung und/oder ein y-Toleranzwert (Ty) für einen Versatz (Vy) des Halbzeuges (10) in eine vorzugsweise um 90 Grad quer zur x-Richtung liegenden y-Richtung und/oder ein Θ-Toleranzwert (TΘ) für einen Winkelversatz (Θ) des Halbzeuges (10) durch eine Drehung um seine Mittelachse (38) vorgegeben wird oder vorgegeben werden,
dass die Lage in x-Richtung und/oder die Lage in y-Richtung und/oder die Drehung erfasst wird oder werden,
und dass die Prüfung abhängig von der erfassten Lage in x-Richtung (Schritt 154) und/oder von der erfassten Lage in y-Richtung (Schritt 156) und/oder von der erfassten Drehung (Schritt 158) sowie abhängig vom x-Toleranzwert (Tx) und/oder vom y-Toleranzwert (Ty) und/oder vom Θ-Toleranzwert (TΘ) ausgeführt wird.

9. Belichtungsanlage, **dadurch gekennzeichnet, dass** die Belichtungsanlage so aufgebaut ist, dass bei ihrem Betrieb ein Verfahren nach einem der vorhergehenden Ansprüche ausgeführt oder Werte zur Ausführung eines Verfahrens nach einem der vorhergehenden Ansprüche erzeugt werden.

10. Datenverarbeitungsanlage, **dadurch gekennzeichnet, dass** die Datenverarbeitungsanlage so konfiguriert ist, dass bei ihrem Betrieb ein Verfahren nach einem der Ansprüche 1 bis 8 ausgeführt wird.

11. Programm mit einer Befehlsfolge, bei deren Ausführung durch einen Prozessor ein Verfahren nach einem der Ansprüche 1 bis 8 ausgeführt wird.
